# EUROPEAN PATENT APPLICATION

(11) **EP 1 925 863 A1**
(43) Date of publication of application: **28.05.2008**
(21) Application number: 06768344.1
(22) Date of filing: 21.07.2006
(51) Int. Cl.: F16K 27/00, H01L 21/02

(54) **FLUID CONTROLLER**

(30) Priority: 12.09.2005 JP 2005263235
(71) Applicant: Fujikin Incorporated, Osaka-shi, Osaka 550-0012 (JP)
(72) Inventor: KOYOMOGI, Mutsunori, Osaka 550-0012 (JP)
(74) Representative: Paul, Dieter-Alfred
(86) International application number: PCT/JP2006/314466
(87) International publication number: WO 2007/032146

(57) **Abstract**

There is provided a fluid control device having no dead volume.

A fluid flow path is constituted by a loop-shaped flow-path portion L, and a first inlet flow-path portion B1, a second inlet flow-path portion B2 and a common outlet flow-path portion B3 which are communicated with a first inlet A1, a second inlet A2 and a common outlet A3 at predetermined portions P1, P2 and P3 of the loop-shaped flow-path portion L. There are provided a first shut-off valve V1 for opening and closing the first inlet flow-path portion B1 and a second shut-off valve V2 for opening and closing the second inlet flow-path portion B2. Accordingly, the first fluid which has flowed into the first inlet A1 and reached the loop-shaped flow-path portion L and the second fluid which has flowed into the second inlet A2 and reached the loop-shaped flow-path portion L are flowed through the loop-shaped flow-path portion L such that each of the first and second fluids are divided into two parts and thereafter are ejected from the common outlet A3.

## Description

### TECHNICAL FIELD

The present invention relates to a fluid control device which has a fluid flow path having a first inlet, a second inlet and a common outlet and blocks and opens the fluid flow path in such a way that the fluid flow path can be used at a first utilization state where a first fluid is flowed into the first inlet and flowed out from the common outlet and at a second utilization state where a second fluid is flowed into the second inlet and flowed out from the common outlet.

### BACKGROUND ART

For example, in fabrication of semiconductors, it is common practice to introduce a process gas into an apparatus through a process-gas inlet, then eject the process gas through a gas outlet, thereafter introduce a purge gas into the apparatus through a purge-gas inlet and eject the purge gas through the same gas outlet. Such a device structured such that two types of gasses are introduced thereinto through different inlets and then are ejected therefrom through a common outlet by switching between these gases in order has been required to reduce so-called dead volumes and improve substitution characteristics. Patent Literature 1 discloses a fluid control device having improved substitution characteristics.

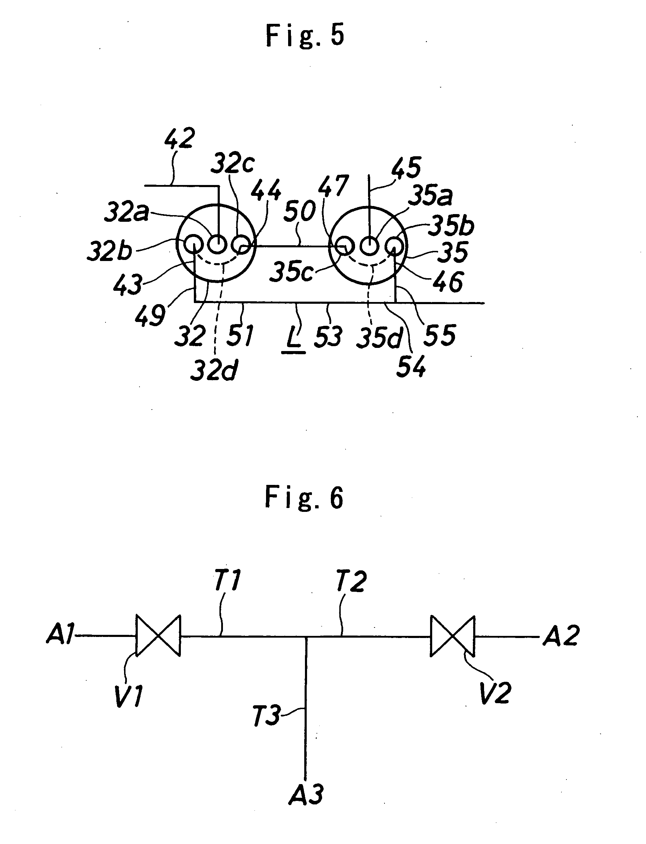

Generally, a fluid control device which blocks and opens a fluid flow path having a first inlet (A1) for introducing a first fluid, a second inlet (A2) for introducing a second fluid and a common outlet (A3) for discharging the first and second fluids has a basic structure including three flow-path portions (T1) (T2) (T3) constituting a T-shaped fluid flow path and a first and second shut-off valves (V1) (V2) provided in the first and second flow-path portions (T1)(T2),respectively, as illustrated in Fig. 6.

Further, the first fluid is flowed into the first inlet flow-path portion (T1) from the first inlet (A1) by opening the first shut-off valve (V1) while closing the second shut-off valve (V2) and, then, the first fluid is ejected from the common outlet (A3) through the common outlet flow-path portion (T3). Subsequently, the second fluid is flowed into the second inlet flow-path portion (T2) from the second inlet (A2) by opening the second shut-off valve (V2) while closing the first shut-off valve (V1) and, then, the second fluid is ejected from the common outlet (A3) through the common outlet flow-path portion (T3). By repeating the aforementioned operations, the first fluid (for example, a process gas) and the second fluid (for example, a purge gas) are discharged to a downstream apparatus such as a mass-flow controller while switching between the first and second fluids in order.

When the first fluid or the second fluid is flowed through the aforementioned structure, the second inlet flow-path portion (T2) or the first inlet flow-path portion (T1) is a fluid path dedicated to any one of the fluids (a portion which, when a different fluid is flowed, stores the previously-flowed fluid and prevents the fluid stored therein from being easily substituted by the aforementioned different fluid since this portion is not a flow path dedicated to the aforementioned different fluid, and such a portion is referred to as a "dead volume"). Such a dead volume reduces the purity of the fluids and also increases the time required for substitution. Accordingly, such a dead volume should be reduced as much as possible.
Patent Literature 1: JP-A. No. 09-303308

### DISCLOSURE OF THE INVENTION

### PROBLEMS TO BE SOLVED BY THE INVENTION

With the fluid control device described in the aforementioned patent literature 1, the substitution characteristics can be improved to a certain degree by making the first inlet flow-path portion (T1) and the second inlet flow-path portion (T2) to have different lengths and by making consideration for the angle between the first inlet flow-path portion (T1) and the second inlet flow-path portion (T2), but its basic structure unavoidably has dead volumes, thereby imposing a limit to the reduction of the dead volume.

It is an object of the present invention to provide a fluid control device having no dead volume.

### MEANS FOR SOLVING THE PROBLEMS

A fluid control device for blocking and opening a fluid flow path having a first inlet for introducing a first fluid, a second inlet for introducing a second fluid and a common outlet for discharging the first fluid and the second fluid, wherein the fluid flow path has a loop-shaped flow-path portion, and a first inlet flow-path portion, a second inlet flow-path portion and a common outlet flow-path portion which are communicated with the first inlet, the second inlet and the common outlet at predetermined portions of the loop-shaped flow-path portion, and the fluid flow path is provided with a first shut-off valve for opening and closing the first inlet flow-path portion and a second shut-off valve for opening and closing the second inlet flow-path portion, such that the first fluid which has flowed into the first inlet and reached the loop-shaped flow-path portion and the second fluid which has flowed into the second inlet and reached the loop-shaped flow-path portion are both flowed through the loop-shaped flow-path portion such that they are divided into two parts and then are ejected from the common outlet.

The shut-off valves can have two ports (an inlet port and an outlet port) or three ports (an inlet port, an outlet port and a communication port). Further, the shut-off valves can be either automatic valves or manual valves.

Each of the first shut-off valve and the second shut-off valve has three ports constituted by an inlet port, an outlet port and a communication port, the inlet port and the outlet port are opened and closed by a valve actuator incorporated in the corresponding shut-off valve, the respective communication ports are communicated with the outlet ports through valve inside communication path portions regardless of the positions of the valve actuators, and the valve inside communication path portions are communicated with each other through a valve outside communication path portion.

In this case, the valve inside communication flow-path portions keep ports provided within the respective corresponding shut-off valves communicated with one another, while the valve outside communication path portion keeps a port provided in one of the shut-off valves communicated with a port provided in the other shut-off valve. The valve outside communication path portion may be constituted by only main-body inside communication path portions provided in the main bodies provided with the valve actuators or may be constituted by main-body inside communication path portions provided in the main bodies provided with the valve actuators and a joint inside communication path portion provided in a joint coupled to the main bodies.

With the aforementioned structure, the fluid control device according to the present invention can be easily applied to a so-called block valve having a first and second shut-off valves mounted to a single block-shaped main body or a so-called integrated fluid control device having fluid control apparatuses such as a first and second shut-off valves placed in an upper stage and plural block-shaped joints placed in a lower stage for supporting the fluid control apparatuses.

In the case where the fluid control device according to the present invention is applied to a block valve, for example, a block-shaped main body can be provided with a first inlet flow-path portion extending from the first inlet provided with a first inlet joint to the inlet port of the first shut-off valve, a first outlet flow-path portion extending from the outlet port of the first shut-off valve to the common outlet provided with an outlet joint, a common outlet flow-path portion which is communicated with the first outlet flow-path portion and is extended to the common outlet provided with the outlet joint, a second inlet flow-path portion extending from the second inlet provided with a second inlet joint to the inlet port of the second shut-off valve, a second outlet flow-path portion which is ejected from the outlet port of the second shut-off valve and is communicated with the common outlet flow-path portion, and a valve outside communication path portion which communicates the communication port of the first shut-off valve to the communication port of the second shut-off valve.

In the case where the fluid control device according to the present invention is applied to an integrated fluid control device, for example, the fluid control device can include plural block-shaped joints which are placed in a lower stage and support the first and second shut-off valves placed in an upper stage, wherein the valve outside communication path portion is constituted by main-body inside communication path portions provided in the main bodies of the respective shut-off valves, and a joint inside communication path portion provided in a joint coupled to the main bodies, and plural block-shaped joints are constituted by a first inlet flow-path portion, a first outlet flow-path portion, a common outlet flow-path portion, a second inlet flow-path portion and a valve outside communication path portion. In this case, the flow paths formed in the respective block-shaped joints can be properly determined according to the relationship with fluid control apparatuses adjacent thereto.

### EFFECTS OF THE INVENTION

With the fluid control device according to the present invention, there is provided a loop-shaped fluid flow path, and fluids introduced from the respective inlets are flowed through the loop-shaped flow-path portions such that they are divided into two parts and then are ejected from the common outlet, which can eliminate flow paths dedicated to any one of the fluids, namely dead volumes.

### BRIEF DESCRIPTION OF THE DRAWINGS

Fig. 1 is a schematic view illustrating the basic structure (principle) of a fluid control device according to the present invention.
Fig. 2 is a view illustrating an embodiment where the present invention is applied to a so-called block valve.
Fig. 3 is a view illustrating, by extracting from Fig. 2, the ports and the flow-path portions.
Fig. 4 is a view illustrating an embodiment where the present invention is applied to a so-called integrated fluid control device.
Fig. 5 is a view illustrating, by extracting from Fig. 4, the ports and the flow-path portions.
Fig. 6 is a schematic view illustrating the basic structure (principle) of a conventional fluid control device.
Fig. 7 is a view illustrating a conventional block valve corresponding to Fig. 2.
Fig. 8 is a view illustrating a conventional block valve corresponding to Fig. 4.

### Description of Reference Characters

- (R): fluid flow path
- (A1): first inlet
- (A2): second inlet
- (A3): common outlet
- (L): loop-shaped flow-path portion
- (B1): first inlet flow-path portion
- (B2): second inlet flow-path portion
- (B3): common outlet flow-path portion
- (V1): first shut-off valve
- (V2): second shut-off valve
- (12): block-shaped main body
- (I3): first shut-off valve
- (I4): second shut-off valve
- (13a) (14a): inlet port
- (13b)(14b): outlet port
- (13c) (14c): communication port
- (13d) (14d): valve inside communication path portion
- (15): first inlet joint
- (15a): first inlet
- (16): second inlet joint
- (16a): second inlet
- (17): outlet joint
- (17a): common outlet
- (21): first inlet flow-path portion
- (22): first outlet flow-path portion
- (23): second inlet flow-path portion
- (24): second outlet flow-path portion
- (25): common outlet flow-path portion
- (26): main-body inside communication path portion
- (32): first shut-off valve
- (35): second shut-off valve
- (32a) (35a): inlet port
- (32b) (35b): outlet port
- (32c) (35c): communication port
- (32d) (35d): valve inside communication path portion
- (42): first inlet flow-path portion
- (44): first main-body inside communication path portion (valve outside communication path portion)
- (45): second inlet flow-path portion
- (47): second main-body inside communication path portion (valve outside communication path portion)
- (49): first outlet flow-path portion
- (50): joint inside communication path portion (valve outside communication path portion)
- (54): common outlet flow-path portion
- (55): second outlet flow-path portion

### BEST MODE FOR CARRYING OUT THE INVENTION

Hereinafter, an embodiment of the present invention will be described, with reference to the drawings. In the following description, the terms "left", "right", "upper" and "lower" designate left, right, upper and lower portions in the figures. Further, fluid flow paths are schematically illustrated in such a way as to illustrate, in the same plane, their components including components which do not exist in the same plane.

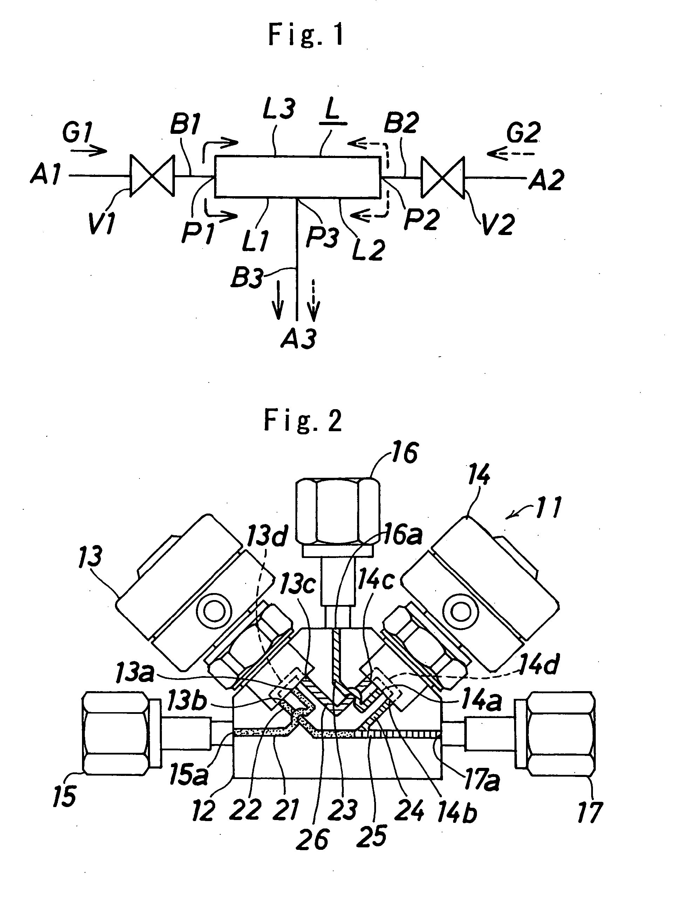

Fig. 1 illustrates the basic structure (principle) of a fluid control device according to the present invention.

The fluid control device blocks and opens a fluid flow path having a first inlet (A1) for introducing a first fluid, a second inlet (A2) for introducing a second fluid, and a common outlet (A3) for discharging the first and second fluids. The fluid flow path is constituted by a loop-shaped flow-path portion (L), and a first inlet flow-path portion (B1), a second inlet flow-path portion (B2) and a common outlet flow-path portion (B3) which are communicated with the first inlet (A1), the second inlet (A2) and the common outlet (A3) at predetermined portions (P1)(P2)(P3) of the loop-shaped flow-path portion (L), wherein there are provided a first shut-off valve (V1) for opening and closing the first inlet flow-path portion (B1) and a second shut-off valve (V2) for opening and closing the second inlet flow-path portion (B2). Accordingly, the first fluid which has flowed into the first inlet (A1) and reached the loop-shaped flow-path portion (L) and the second fluid which has flowed into the second inlet (A2) and reached the loop-shaped flow-path portion (L) are flowed through the loop-shaped flow-path portion (L) such that each of the first and second fluids are divided into two parts and thereafter are ejected from the common outlet (A3).

Accordingly, when the first fluid (G1) is flowed into the first inlet flow-path portion (B1) from the first inlet (A1) by opening the first shut-off valve (V1) while closing the second shut-off valve (V2), the first fluid (G1) passes through the flow-path portion (L1) of the loop-shaped flow-path portion (L1) closer to the common outlet (A3) and also passes through the portions (L3) (L2) thereof farther from the common outlet (A3), then reaches the common outlet flow-path portion (B3) and then is ejected from the common outlet (A3), as illustrated by solid-line arrows in the figure. Further, when the second fluid (G2) is flowed into the second inlet flow-path portion (B2) from the second inlet (A2) by opening the second shut-off valve (V2) while closing the first shut-off valve (V1), the second fluid (G2) passes through the flow-path portion (L2) of the loop-shaped flow-path portion (L1) closer to the common outlet (A3) and also passes through the portions (L3) (L1) thereof farther from the common outlet (A3), then reaches the common outlet flow-path portion (B3) and then is ejected from the common outlet (A3), as illustrated by broken-line arrows in the figure.

Accordingly, when the first fluid (G1) is flowed, the portion (L2) corresponding to the flow path designated by (T2) in Fig. 6 does not form a dead volume and, when the second fluid (G2) is flowed, the portion (L1) corresponding to the flow path designated by (T1) in Fig. 6 does not form a dead volume, thereby providing a fluid control device having no dead volume.

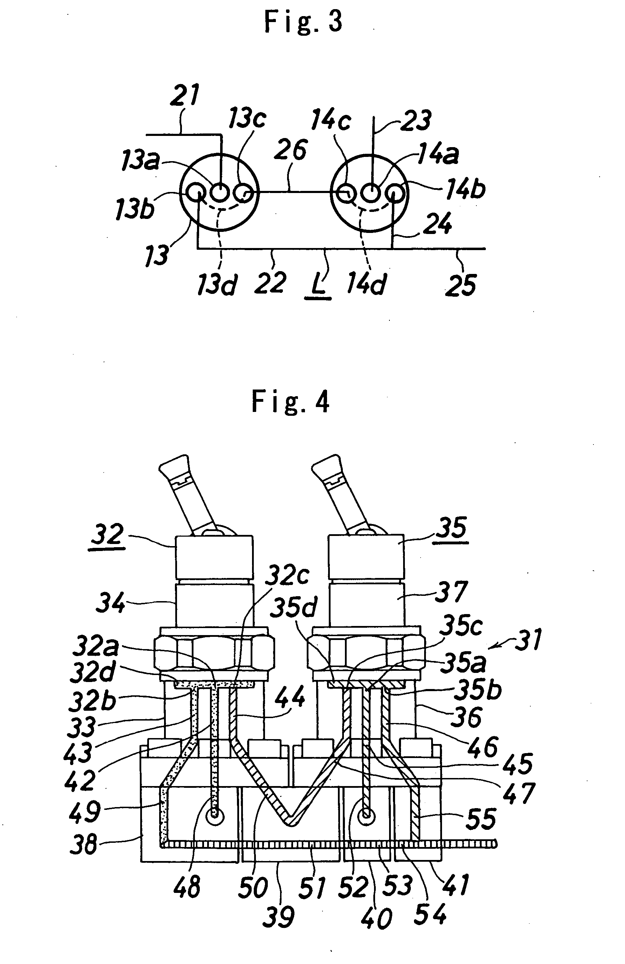

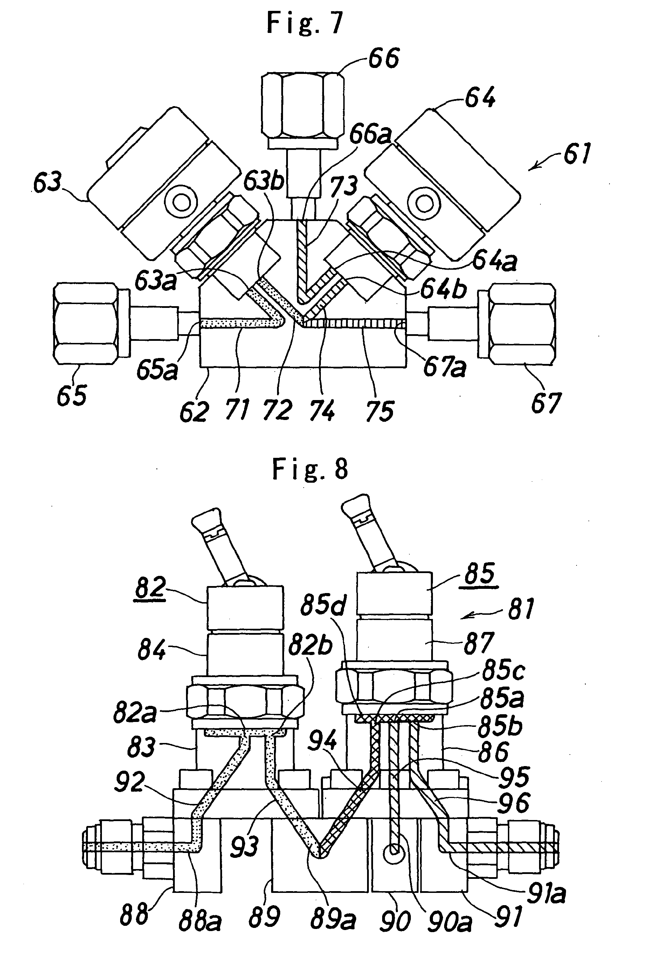

Fig. 2 and Fig. 3 illustrate an embodiment where the principle of the aforementioned fluid control device is applied to a so-called block valve. Fig. 7 illustrates a block valve in the prior art.

In Fig. 7, the conventional block valve (fluid control device) (61) includes a block-shaped main body (62) having an upper surface having inclined surfaces in its left and right sides, a first and second shut-off valves (63) (64) provided on the left and right inclined surfaces of the block-shaped main body (62), a first and second inlet joints (65) (66) provided on the left surface and the center portion of the upper surface of the block-shaped main body (62), and an outlet joint (67) provided on the right surface of the block-shaped main body (62).

The first and second shut-off valves (63) (64) are diaphragm valves each including two ports, namely an inlet port (63a) (64a) and an outlet port (63b) (64b), wherein these inlet ports (63a)(64a) and outlet ports (63b)(64b) are opened and closed by valve actuators (not illustrated) incorporated in the shut-off valves.

The block-shaped main body (62) is provided with a first inlet flow-path portion (71) extending from a first inlet (65a) provided with the first inlet joint (65) to the inlet port (63a) of the first shut-off valve (63), a first outlet flow-path portion (72) extending from the outlet port (63b) of the first shut-off valve (63) toward a common outlet (67a) provided with the outlet joint (67), a common outlet flow-path portion (75) which is communicated with the first outlet flow-path portion (72) and reaches the common outlet (67a) provided with the outlet joint (67), a second inlet flow-path portion (73) which extends from a second inlet (66a) provided with the second inlet joint (66) and reaches the inlet port (64a) of the second shut-off valve (64), and a second outlet flow-path portion (74) which is ejected from the outlet port (64b) of the second shut-off valve (64) and is merged with the first outlet flow-path portion (72) to be communicated with the common outlet flow-path portion (75).

When a first fluid is flowed into the conventional block valve (61) from the first inlet joint (65) by opening the first shut-off valve (63) while closing the second shut-off valve (64), the first fluid passes through the first inlet (65a), the first inlet flow-path portion (71), the inlet port (63a) of the first shut-off valve (63), the outlet port (63b) of the first shut-off valve (63), the first outlet flow-path portion (72), the common outlet flow-path portion (75) and the common outlet (67a) and, then, is ejected from the outlet joint (67). Further, when a second fluid is flowed thereinto from the second inlet joint (66) by opening the second shut-off valve (64) while closing the first shut-off valve (63), the second fluid passes through the second inlet (66a), the second inlet flow-path portion (73), the inlet port (64a) of the second shut-off valve (64), the outlet port (64b) of the second shut-off valve (64), the second outlet flow-path portion (74), the common outlet flow-path portion (75) and the common outlet (67a) and, then, is ejected from the outlet joint (67). Accordingly, when the first fluid is flowed, the second outlet flow-path portion (74) forms a dead volume and, when the second fluid is flowed, the first outlet flow-path portion (72) forms a dead volume.

As illustrated in Fig. 2, the block valve (the fluid control device) (11) according to the present invention includes a block-shaped main body (12) having an upper surface with inclined surfaces in its left and right sides, a first and second shut-off valves (13) (14) provided on the left and right inclined surfaces of the block-shaped main body (12), a first and second inlet joints (15) (16) provided on the left surface and the center portion of the upper surface of the block-shaped main body (12), and an outlet joint (17) provided on the right surface of the block-shaped main body (12).

The first and second shut-off valves (13) (14) are diaphragm valves each including three ports, namely an inlet port (13a) (14a), an outlet port (13b) (14b) and a communication port (13c) (14c), wherein these inlet ports (13a) (14a) and outlet ports (13b) (14b) are opened and closed by valve actuators (not illustrated) incorporated in the shut-off valves, and the communication ports (13c) (14c) are communicated with the outlet ports (13b) (14b) through valve inside communication flow-path portions (13d) (14d).

The block-shaped main body (12) is provided with a first inlet flow-path portion (21) extending from a first inlet (15a) provided with the first inlet joint (15) to the inlet port (13a) of the first shut-off valve (13), a first outlet flow-path portion (22) extending from the outlet port (13b) of the first shut-off valve (13) toward a common outlet (17a) provided with the outlet joint (17), a common outlet flow-path portion (25) which is communicated with the first outlet flow-path portion (22) and reaches the common outlet (17a) provided with the outlet joint (17), a second inlet flow-path portion (23) extending from a second inlet (16a) provided with the second inlet joint (16) to the inlet port (14a) of the second shut-off valve (14), a second outlet flow-path portion (24) which is ejected from the outlet port (14b) of the second shut-off valve (14) and is communicated with the common outlet flow-path portion (25), and a valve outside communication flow-path portion (26) which communicates the communication port (13c) of the first shut-off valve (13) to the communication port (14c) of the second shut-off valve (14).

Fig. 3 illustrates the ports (13a) (13b) (13c) (14a) (14b) (14c) and the flow-path portions (13d) (14d) (21) (22) (23) (24) (25) (26) by extracting them from Fig. 2. As can be seen from the figure, the block valve (11) according to the present invention is provided with a loop-shaped flow-path portion (L) constituted by the first outlet flow-path portion (22), the second outlet flow-path portion (24), the valve inside communication path portion (14d) in the second shut-off valve (14), the valve outside communication path portion (26), and the valve inside communication path portion (13d) in the first shut-off valve (13).

When a first fluid is flowed into the block valve (11) according to the present invention from the first inlet joint (15) by opening the first shut-off valve (13) while closing the second shut-off valve (14), a portion of the first fluid passes through the first inlet (15a), the first inlet flow-path portion (21), the inlet port (13a) of the first shut-off valve (13), the outlet port (13b) of the first shut-off valve (13), the first outlet flow-path portion (22), the common outlet flow-path portion (25) and the common outlet (17a) and, then, is ejected from the outlet joint (17) (similarly to in Fig. 7), while the remaining portion of the first fluid is branched in the outlet port (13b) of the first shut-off valve (13), then passes through the valve inside communication path portion (13d) of the first shut-off valve (13), the communication port (13c) of the first shut-off valve (13), the valve outside communication path portion (26), the communication port (14c) of the second shut-off valve (14), the valve inside communication path portion (14d) of the same, the outlet port (14b) of the same and the second outlet flow-path portion (24), then is merged with the common outlet flow-path portion (25) and, then, is ejected from the outlet joint (17).

When a second fluid is flowed thereinto from the second inlet joint (16) by opening the second shut-off valve (14) while closing the first shut-off valve (13), a portion of the second fluid passes through the second inlet (16a), the second inlet flow-path portion (23), the inlet port (14a) of the second shut-off valve (14), the outlet port (14b) of the same, the second outlet flow-path portion (24), the common outlet flow-path portion (25) and the common outlet (17a) and then is ejected from the outlet joint (17) (similarly to in Fig. 7), while the remaining portion of the second fluid is branched in the outlet port (14b) of the second shut-off valve (13), then passes through the valve inside communication path portion (14d) of the second shut-off valve (14), the communication port (14c) of the same, the valve outside communication path portion (the main-body inside communication path portion) (26), the communication port (13c) of the first shut-off valve (13), the valve inside communication path portion (13d) of the same, the outlet port (13b) of the same and the first outlet flow-path portion (22), then is merged with the common outlet flow-path portion (25) and then is ejected from the outlet joint (17).

Namely, as a result of the provision of the loop-shaped flow-path portion (L)=(22) (24) (14d) (26) (13d), the portions (22) (24) corresponding to the first outlet flow-path portion (72) and the second outlet flow-path portion (74) which form dead volumes in Fig. 7 form no dead volume, thereby providing a fluid control device having no dead volume.

Fig. 4 and Fig. 5 illustrate an embodiment where the principle of the aforementioned fluid control device is applied to a blocking/opening device for a so-called integrated fluid control device. Fig. 8 illustrates a blocking/opening device in the prior art.

In Fig. 8, the conventional blocking/opening device (fluid control device) (81) includes a first shut-off valve (82) constituted by a first valve main body (83) and a first valve actuator (84), a second shut-off valve (85) constituted by a second valve main body (86) and a second valve actuator (87), an inlet-joint-incorporated block-shaped joint (88) which supports the left portion of the first valve main body (83), a communication block-shaped joint (89) which supports the right portion of the first valve main body (83) and the left portion of the second valve main body (86), an inlet block-shaped joint (90) which supports the center portion of the second valve main body (86), and an outlet-joint-incorporated block-shaped joint (91) which supports the right portion of the second valve main body (86).

The first shut-off valve (82) is a manual two-port diaphragm valve having an input port (82a) and an output port (82b). The first valve main body (83) is provided with a first inlet flow-path portion (92) communicated with an L-shaped flow path (88a) in the inlet-joint-incorporated block-shaped joint (88) and a first outlet flow-path portion (93) communicated with a V-shaped flow path (89a) in the communication block-shaped joint (89).

The second shut-off valve (85) is a manual three-port diaphragm valve having an inlet port (85a), an outlet port (85b) and a communication port (85c), wherein the communication port (85c) is communicated with the outlet port (85b) through a valve inside communication path portion (85d). The second valve main body (86) is provided with a main-body inside communication path portion (94) communicated with the V-shaped flow path (89a) in the communication block-shaped joint (89), a second inlet flow-path portion (95) communicated with an L-shaped flow path (90a) in the inlet block-shaped joint (90), and a second outlet flow-path portion (96) communicated with an L-shaped flow path (91a) in the outlet-joint-incorporated block-shaped joint (91). The second outlet flow-path portion (96) also serves as an outlet flow-path portion for the first fluid and forms a common outlet flow-path portion.

When a first fluid is flowed into the conventional blocking/opening device (81) from the inlet-joint-incorporated block-shaped joint (88) by opening the first shut-off valve (82) while closing the second shut-off valve (85), the first fluid reaches the inlet port (82a) of the first shut-off valve (82) through the first inlet flow-path portion (92) and, therefrom, the first fluid passes through the outlet port (82b) of the first shut-off valve (82), the first outlet flow-path portion (93) of the same, the V-shaped flow path (89a) in the communication block-shaped joint (89), the main-body inside communication path portion (94) in the second shut-off valve (85), the communication port (85c) of the same, the valve inside communication path portion (85d) of the same, the outlet port (85b) of the same, the second outlet flow-path portion (96) of the same and the L-shaped flow path (91a) in the outlet-joint-incorporated block-shaped joint (91), and, then, is ejected to the outside. Further, when a second fluid is flowed thereinto from the L-shaped flow path (90a) in the inlet block-shaped joint (90) by opening the second shut-off valve (85) while closing the first shut-off valve (82), the second fluid reaches the inlet port (85a) of the second shut-off valve (85) through the second inlet flow-path portion (95) and, therefrom, the second fluid passes through the outlet port (85b) of the second shut-off valve (85), the second outlet flow-path portion (96) of the same and the L-shaped flow path (91a) in the outlet-joint-incorporated block-shaped joint (91) and, then, is ejected to the outside. Accordingly, no dead volume exists when the first fluid is flowed, but the first outlet flow-path portion (93) in the first shut-off valve (82), the V-shaped flow path (89a) in the communication block-shaped joint (89) and the main-body inside communication path portion (94) in the second shut-off valve (85) form a dead volume when the second fluid is flowed.

As illustrated in Fig. 4, the blocking/opening device (fluid control device) (31) according to the present invention includes a first shut-off valve (32) constituted by a first valve main body (33) and a first valve actuator (34), a second shut-off valve (35) constituted by a second valve main body (36) and a second valve actuator (37), a first inlet block-shaped joint (38) which supports the left portion of the first valve main body (33), a communication block-shaped joint (39) which supports the right portion of the first valve main body (33) and the left portion of the second valve main body (36), a second inlet block-shaped joint (40) which supports the center portion of the second valve main body (36), and an outlet block-shaped joint (41) which supports the right portion of the second valve main body (36).

The first shut-off valve (32) is a manual 3-port diaphragm valve having an inlet port (32a) positioned at the center, an outlet port (32b) positioned in the left side and a communication port (32c) positioned in the right side. Similarly, the second shut-off valve (35) is a manual 3-port diaphragm valve having an inlet port (35a) positioned at the center, an outlet port (35b) positioned in the right side and a communication port (35c) positioned in the left side. Further, the respective communication ports (32c) (35c) are communicated with the outlet ports (32b) (35b) through valve inside communication path portions (32d) (35d).

The first valve main body (33) is provided with a first inlet flow-path portion (42) which is extended just downwardly from the inlet port (32a) and is opened downwardly, a first outlet flow-path portion (43) which is extended diagonally downward and leftward from the outlet port (32b) and is opened downwardly, and a first main-body inside communication path portion (44) which is extended diagonally downward and rightward from the communication port (32c) and is opened downwardly.

The second valve main body (36) is provided with a second inlet flow-path portion (45) which is extended just downwardly from the inlet port (35a) and is opened downwardly, a second outlet flow-path portion (46) which is extended diagonally downward and rightward from the outlet port (35b) and is opened downwardly, and a second main-body inside communication path portion (47) which is extended diagonally downward and leftward from the communication port (35c) and is opened downwardly.

The first inlet block-shaped joint (38) is provided with a joint inside inlet flow-path portion (48) having an L-shape (when viewed from the left side) which is communicated with the first inlet flow-path portion (42), and a joint inside outlet flow-path portion (49) having an L-shape which is communicated with the lower-end opening of the first outlet flow-path portion (43) and relays it to the surface which faces to the communication block-shaped joint (39).

The communication block-shaped joint (39) is provided with a V-shaped joint inside communication path portion (50) which communicates the first main-body inside communication path portion (44) to the second main-body inside communication path portion (47), and a linear-shaped joint inside outlet flow-path portion (51) which is communicated with the joint inside outlet flow-path portion (49) in the first inlet block-shaped joint (38) and relays it to the surface which faces to the second inlet block-shaped joint (40).

The second inlet block-shaped joint (40) is provided with a joint inside inlet flow-path portion (52) having an L-shape (when viewed from the left side) which is communicated with the second inlet flow-path portion (45), and a linear-shaped joint inside outlet flow-path portion (53) which is communicated with the joint inside outlet flow-path portion (51) in the communication block-shaped joint (39) and relays it to the surface which faces to the outlet block-shaped joint (41).

The outlet block-shaped joint (41) is provided with a joint inside outlet flow-path portion (54) which is communicated with the joint inside outlet flow-path portion (53) in the second inlet block-shaped joint (40) and communicates it to the outside, and a joint inside outlet flow-path portion (55) which merges the second outlet flow-path portion (46) with the joint inside outlet flow-path portion (54). The joint inside outlet flow-path portion (54) for communication to the outside forms, at its outlet portion, a common outlet flow-path portion for the first and second fluids.

Fig. 5 illustrates the ports (32a) (32b) (32c) (35a) (35b) (35c) and the flow-path portions (32d) (33) (35d) (36) (42) (43) (44) (45) (46) (47) (51) (52) (53) (54) (55) by extracting them from Fig. 4. As can be seen from the figure, the blocking/opening device (31) according to the present invention is provided with a loop-shaped flow path portion (L) constituted by the first outlet flow-path portion (43) in the first valve main body (33), the joint inside outlet flow-path portion (49) in the first inlet block-shaped joint (38), the joint inside outlet flow-path portion (51) in the communication block-shaped joint (39), the joint inside outlet flow-path portion (53) in the second inlet block-shaped joint (40), the joint inside outlet flow-path portions (54) (55) in the outlet block-shaped joint (41), the second outlet flow-path portion (46) in the second valve main body (36), the valve inside communication path portion (35d) in the second shut-off valve (35), the second main-body inside communication path portion (47) in the second valve main body (36), the joint inside communication path portion (50) in the communication block-shaped joint (39), the first main-body inside communication flow-path portion (44) in the first valve main body (33), and the valve inside communication path portion (32d) in the first shut-off valve (32). In this case, the first main-body inside communication path portion (44), the joint inside communication path portion (50) in the communication block-shaped joint (39) and the second main-body inside communication path portion (47) form a valve outside communication path portion which keeps the communication port (32c) of the first shut-off valve (32) and the communication port (35c) of the second shut-off valve (35) communicated with each other.

When a first fluid is flowed into the blocking/opening device (31) according to the present invention from the joint inside inlet flow-path portion (48) in the first inlet block-shaped joint (38) by opening the first shut-off valve (32) while closing the second shut-off valve (35), the first fluid reaches the inlet port (32a) of the first shut-off valve (32) through the first inlet flow-path portion (42) and, therefrom, the first fluid passes through the communication port (32c) of the first shut-off valve (32), the first main-body inside communication path portion (44), the joint inside communication path portion (50) in the communication block-shaped joint (39), the second main-body inside communication path portion (47), the communication port (35c) of the second shut-off valve (35), the outlet port (35b) of the same, the second outlet flow-path portion (46) and the joint inside outlet flow-path portions (55) (54) in the outlet block-shaped joint (41) and then is ejected to the outside (similarly to in Fig. 8) and, also, the first fluid passes through the outlet port (32b) of the first shut-off valve (32), the first outlet flow-path portion (43), the joint inside outlet flow-path portion (49) in the first inlet block-shaped joint (38), the joint inside outlet flow-path portion (51) in the communication block-shaped joint (39), the joint inside outlet flow-path portion (53) in the second inlet block-shaped joint (40) and the joint inside outlet flow-path portion (54) in the outlet block-shaped joint (41) and, then, is ejected to the outside.

Further, when a second fluid is flowed thereinto from the joint inside inlet flow-path portion (52) in the second inlet block-shaped joint (40) by opening the second shut-off valve (35) while closing the first shut-off valve (32), the second fluid reaches the inlet port (35a) of the second shut-off valve (35) through the second inlet flow-path portion (45) and, therefrom, the second fluid passes through the outlet port (35b) of the second shut-off valve (35), the second outlet flow-path portion (46) and the outlet flow-path portions (55) (54) in the outlet block-shaped joint (41) and, then, is ejected to the outside (similarly to in Fig. 8) and, also, the second fluid passes through the communication port (35c) of the second shut-off valve (35), the second main-body inside communication path portion (47), the joint inside communication path portion (50) in the communication block-shaped joint (39), the first main-body inside communication path portion (44), the communication port (32c) of the first shut-off valve (32), the outlet port (32b) of the same, the first outlet flow-path portion (43), the joint inside outlet flow-path portion (49) in the first inlet block-shaped joint (38), the joint inside outlet flow-path portion (51) in the communication block-shaped joint (39), the joint inside outlet flow-path portion (53) in the second inlet block-shaped joint (40) and the outlet flow-path portion (54) in the outlet block-shaped joint (41) and, then, is ejected to the outside.

Namely, as a result of the provision of the loop-shaped flow-path portion (L)=(43) (49) (51) (53) (54) (55) (35d) (47) (50) (44) (32d), both the first and second fluids flow through the flow-path portions (44) (50) (47) corresponding to the outlet flow-path portion (93) of the first shut-off valve (82), the joint inside communication path portion (89a) in the communication block-shaped joint (89) and the main-body inside communication path portion (94) of the second shut-off valve (85) which form dead volumes in Fig. 8 and, therefore, these portions form no dead volume and, also, both the first and second fluids flow through the flow-path portions (43) (49) (51) (53) (54) which are provided in addition to those illustrated in Fig. 8 and, therefore, these flow-path portions form no dead volumes, thereby providing a blocking/opening device (31) having no dead volume.

Further, the shapes of the shut-off valves (32) (35), the number of block-shaped joints (38) (39) (40) (41), the shapes of their contours and the shapes of respective flow-path portions within the joints in Fig. 4 are not limited to those described above and are varied depending on the relationship with a fluid control apparatus adjacent to the first shut-off valve (32) or the second shut-off valve (35) and the like.

### INDUSTRIAL APPLICABILITY

According to the present invention, there is provided a fluid control device which has a fluid flow path provided with a first inlet, a second inlet and a common outlet and blocks and opens the fluid flow path. With the present invention, it is possible to eliminate the dead volume in the fluid flow path.

## Claims

1. A fluid control device for blocking and opening a fluid flow path comprising a first inlet for introducing a first fluid, a second inlet for introducing a second fluid and a common outlet for discharging the first fluid and the second fluid,
wherein the fluid flow path comprises a loop-shaped flow-path portion, and a first inlet flow-path portion, a second inlet flow-path portion and a common outlet flow-path portion which are communicated with the first inlet, the second inlet and the common outlet at predetermined portions of the loop-shaped flow-path portion, and the fluid flow path is provided with a first shut-off valve for opening and closing the first inlet flow-path portion and a second shut-off valve for opening and closing the second inlet flow-path portion, such that the first fluid which has flowed into the first inlet and reached the loop-shaped flow-path portion and the second fluid which has flowed into the second inlet and reached the loop-shaped flow-path portion are both flowed through the loop-shaped flow-path portion such that they are divided into two parts and then are ejected from the common outlet.

2. The fluid control device according to claim 1, wherein
each of the first shut-off valve and the second shut-off valve has three ports constituted by an inlet port, an outlet port and a communication port, the inlet port and the outlet port are opened and closed by a valve actuator incorporated in the corresponding shut-off valve, the respective communication ports are communicated with the outlet ports through valve inside communication path portions regardless of the positions of the valve actuators, and the valve inside communication path portions are communicated with each other through a valve outside communication path portion.

3. The fluid control device according to claim 2, wherein
the first shut-off valve and the second shut-off valve are mounted to a single block-shaped main body, and the block-shaped main body is provided with a first inlet flow-path portion extending from the first inlet provided with a first inlet joint to the inlet port of the first shut-off valve, a first outlet flow-path portion extending from the outlet port of the first shut-off valve toward the common outlet provided with an outlet joint, a common outlet flow-path portion which is communicated with the first outlet flow-path portion and reaches the common outlet provided with the outlet joint, a second inlet flow-path portion extending from the second inlet provided with a second inlet joint to the inlet port of the second shut-off valve, a second outlet flow-path portion which is ejected from the outlet port of the second shut-off valve and is communicated with the common outlet flow-path portion, and a valve outside communication path portion which communicates the communication port of the first shut-off valve to the communication port of the second shut-off valve.

4. The fluid control device according to claim 2, comprising plural block-shaped joints which are placed in a lower stage and support the first and second shut-off valves placed in an upper stage,
wherein the valve outside communication path portion is constituted by main-body inside communication path portions provided in the main bodies of the respective shut-off valves, and a joint inside communication path portion provided in a joint coupled to the main bodies.
